# EUROPEAN PATENT APPLICATION

(11) **EP 3 324 258 A1**
(43) Date of publication of application: **23.05.2018**
(21) Application number: 17200759.3
(22) Date of filing: 09.11.2017
(51) Int. Cl.: G05B 23/02

(54) **MODELING TO DETECT GAS TURBINE ANOMALIES**

(30) Priority: 17.11.2016 US 201615354997
(71) Applicant: General Electric Company, Schenectady, NY 12345 (US)
(72) Inventor: FLAVIN, Daniel Joseph, Greenville, SC 29615-4614 (US); SOPCIC, Paige Marie, Greenville, SC 29615 (US); FULLER, Jason Dean, Greenville, SC 29615-4614 (US); CROTHERS, Sarah Lori, Greenville, SC 29615 (US)
(74) Representative: Lee, Brenda

(57) **Abstract**

A turbine system 10 includes a number of sensors 22, each sensor disposed in a respective location of the turbine system and generating a respective signal, a controller 24 capable of generating a controller output, the controller output being at least partially derived from the respective signal from the number of sensors, and an electronic device including memories storing processor-executable routines, and one or more processors 28, 29 configured to access and execute the one or more routines encoded by the one or more memories 26, 27 wherein the one or more routines, when executed, cause the one or more processors to receive one or more inputs, the inputs being at least one of the respective signals from one of the number of sensors, the controller output, or some combination thereof, and generate an audio output using one or more models that incorporate the one or more inputs.

## Description

### BACKGROUND

The subject matter disclosed herein relates to turbomachinery, and more specifically, to modeling to detect gas turbine anomalies, events, or problems using generated audio output.

Plant operators maybe removed from the physical noises of the equipment (e.g., gas turbines) in plants as the equipment is running. For example, the operator may be monitoring the operation of the plant at a location remote from the plant, sound-proofing of the equipment operating in the plants may reduce the audible noise emitted, or the like. As such, the operators oftentimes rely on alarms created by a control system to protect the equipment. However, operators may become desensitized to or ignore the alarms for significant periods of time, which may lead to an undesirable operating condition of the equipment occurring. In addition, there may be certain locations of the equipment where including sensors is not feasible (e.g., physically, logistically, thermally, etc.). Nevertheless, operators may find it desirable to learn about behavior characteristics at those locations when determining whether an anomaly, event, or problem is present.

### BRIEF DESCRIPTION

Certain embodiments commensurate in scope with the originally claimed subject matter are summarized below. These embodiments are not intended to limit the scope of the claimed subject matter, but rather these embodiments are intended only to provide a brief summary of possible forms of the subject matter. Indeed, the subject matter may encompass a variety of forms that may be similar to or different from the embodiments set forth below.

In one embodiment, a turbine system includes a number of sensors, each sensor disposed in a respective location of the turbine system and generating a respective signal, a controller capable of generating a controller output, the controller output being at least partially derived from the respective signal from the number of sensors, and an electronic device including memories storing processor-executable routines, and one or more processors configured to access and execute the one or more routines encoded by the one or more memories wherein the one or more routines, when executed, cause the one or more processors to receive one or more inputs, the inputs being at least one of the respective signals from one of the number of sensors, the controller output, or some combination thereof, and generate an audio output using one or more models that incorporate the one or more inputs.

In one embodiment, a device includes one or more memories storing one or more processor-executable routines, and one or more processors configured to access and execute the one or more routines encoded by the one or more memories wherein the one or more routines, when executed, cause the one or more processors to receive one or more inputs, the inputs being at least one of a respective signal from a number of sensors of a turbine system, an output of a controller of the turbine system, or some combination thereof, and generate an audio output using one or more models that incorporate the one or more inputs.

In one embodiment, one or more tangible, non-transitory computer-readable mediums includes instructions that, when executed by one or more processors, cause the one or more processors to receive one or more inputs, the inputs beings at least one of a respective signal from a number of sensors, a controller output, or some combination thereof, wherein each sensor of the number of sensors are disposed at a respective location of a turbine system, and generate an audio output using one or more models that incorporate the one or more inputs.

### BRIEF DESCRIPTION OF THE DRAWINGS

These and other features, aspects, and advantages of the present subject matter will become better understood when the following detailed description is read with reference to the accompanying drawings in which like characters represent like parts throughout the drawings, wherein:
FIG. 1 is a block diagram of a turbine system that enables modeling to detect anomalies, events, or problems via generated audio output using one or more sensors, in accordance with an embodiment;
FIG. 2 is a schematic diagram of example locations of the turbine system where the sensors may be located, in accordance with an embodiment;
FIG. 3 is a screenshot of a graphical user interface for utilization in listening to generated audio output from the turbine system, in accordance with an embodiment; and
FIG. 4 is a flow chart illustrating an embodiment of a method for modeling to detect anomalies, events, or problems via generated audio output, in accordance with an embodiment.

### DETAILED DESCRIPTION

One or more specific embodiments of the present subject matter will be described below. In an effort to provide a concise description of these embodiments, all features of an actual implementation may not be described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

When introducing elements of various embodiments of the present subject matter, the articles "a," "an," "the," and "said" are intended to mean that there are one or more of the elements. The terms "comprising," "including," and "having" are intended to be inclusive and mean that there may be additional elements other than the listed elements.

As previously discussed, plant operators may ignore or become desensitized to certain alarms related to gas turbine health that are emitted at control stations remote from the gas turbine. As such, gas turbine equipment issues may arise at the plants that result in significant equipment downtime (e.g., the equipment is not operational) or maintenance costs. Further, it may not be feasible (e.g., physically, logistically, thermally, etc.) to install sensors in certain locations of the gas turbine equipment. Thus, it is now generally recognized that improved techniques for detecting gas turbine anomalies, events, or problems are desirable.

Accordingly, embodiments of the present disclosure generally relate to a system and method for detecting modeled gas turbine anomalies, events, or problems using generated audio output. That is, some embodiments enable gas turbine operators to monitor modeled behavior to detect anomalies, events, or problems via generated audible noise using data obtained from sensors included in or attached to the turbine system and/or output from a controller. For example, the model may receive inputs from various available instrumentation (e.g., sensors) and control parameters to simulate behavior of desired locations or phenomenon. The sensors may be disposed in or on various locations of the turbine system, such as the compressor, intake (e.g., inlet), turbine, and the like. For example, the sensor signals may be output from thermocouples and/or dynamic pressure transmitters in various locations of the turbine system (e.g., sensors near the intake and representing valve stroke of the gas entering the intake and the amount open of inlet guide vanes (IGV) and inlet bleed heat (IBH), sensor at fuel intake of combustion system, pressure sensors at the intake, pressure sensors at compressor discharge, thermocouples at compressor discharge, thermocouples at turbine exhaust, and so forth). As may be appreciated, it may not be feasible to dispose sensors in or on certain portions of the turbine system 10 due to various constraints (e.g., physical, thermal, etc.). Thus, in some embodiments, data from the sensors included in or on the turbine system and/or output from a controller may be used to model behavior (e.g., pressure dynamics, thermal dynamics, fluid dynamics, etc.) and generate audio representing that behavior in the locations without sensors to enable detecting anomalies, events, or problems in the locations without sensors. In some embodiments, the data from the sensors may be obtained during any period of operation (e.g., startup, full operation, and/or shutdown) of the turbine system.

As described below, the sensors may include dynamic pressure sensors, thermocouple sensors, and/or other sensors that are already present in the gas turbine. Leveraging the existing sensors may reduce new instrumentation and installation costs. Additionally, the sensors may include clearance probes, optical probes, microphones, accelerometers or strain gages, dynamic pressure sensors, and the like. The sensors may be located in any feasible location on the gas turbine or within the gas turbine, such as in an inlet, compressor, turbine, holes of a casing of the turbine system, borescope ports, fuel intake, or the like. In some embodiments, the sensors may emit signals to a controller and/or computing device executing a software application. The software application may cause a processor to model behavior within certain locations in the gas turbine, generate audio signals representing the behavior, and output the audio signals via audio output devices of the controller and/or computing device. The plant operators may listen to the audio output generated using modeled behavior and detect anomalies, events, or problems based on a change in the sound of the turbine system, rather than solely relying on controller alarms. The anomalies, events, or problems that are modeled may include flutter, rotating stall, whistling caused by resonance of the compressor bleed cavities and/or various cavities or wheel spaces in the turbine, items (e.g., bolts, debris, etc.) left inside the turbine system when the system is operational, compressor surge, and the like.

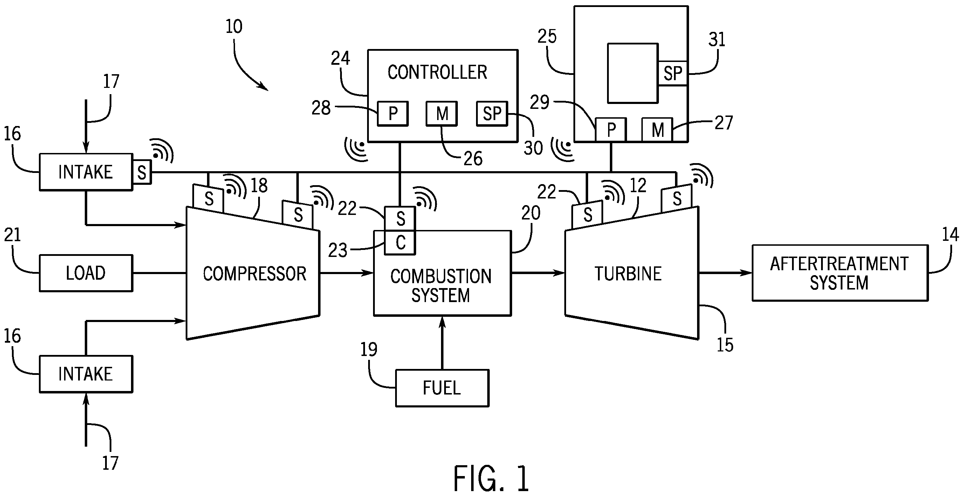

Turning now to the drawings, FIG. 1 illustrates a block diagram of a turbine system 10 that enables modeling to detect anomalies, events, or problems via generated audio output, in accordance with an embodiment of the present disclosure. In some embodiments, the turbine system 10 includes a turbine engine 12 and an aftertreatment system 14. It should be noted that the aftertreatment system 14 is included optionally and the turbine system 10 may include some other system (e.g., heat recovery steam generator) instead of the aftertreatment system 14 or another system in addition to the aftertreatment system 14. In some embodiments, the turbine system 10 does not include the aftertreatment system 14. In certain embodiments, the turbine system 10 maybe a power generation system. The turbine system 10 may use liquid or gas fuel, such as natural gas and/or a hydrogen-rich synthetic gas, to run the turbine system 10. As shown, the turbine system 10 includes an air intake section 16, a compressor 18, a combustion system 20, and the turbine 12. The turbine 12 may be drivingly coupled to the compressor 18 via a shaft. In operation, air enters the turbine system 10 through the air intake section 16 (indicated by the arrows 17) and is pressurized in the compressor 18. The intake section 16 may include an inlet. The compressor 18 may include a number of compressor blades coupled to the shaft. The rotation of the shaft causes rotation of the compressor blades, thereby drawing air into the compressor 18 and compressing the air prior to entry into the combustion system 20.

As compressed air exits the compressor 18 and enters the combustion system 20, the compressed air 17 may be mixed with fuel 19 for combustion within one or more combustion cans 23. For example, the combustion cans 23 may include one or more fuel nozzles that may inject a fuel-air mixture into the combustion cans 23 in a suitable ratio for optimal combustion, emissions, fuel consumption, power output, and so forth. The combustion of the air 17 and fuel 19 generates hot pressurized exhaust gases, which may then be utilized to drive one or more turbine blades within the turbine 12. In operation, the combustion gases flowing into and through the turbine 12 flow against and between the turbine blades, thereby driving the turbine blades and, thus, the shaft into rotation to drive a load 21, such as an electrical generator in a power plant. As discussed above, the rotation of the shaft also causes blades within the compressor 18 to draw in and pressurize the air received by the intake 16.

The combustion gases that flow through the turbine 12 may exit the downstream end 15 of the turbine 12 as a stream of exhaust gas. The exhaust gas stream may continue to flow in the downstream direction towards the aftertreatment system 14. For instance, the downstream end 15 maybe fluidly coupled to the aftertreatment system 14. As a result of the combustion process, the exhaust gas may include certain byproducts, such as nitrogen oxides (NOₓ), sulfur oxides (SOₓ), carbon oxides (COₓ), and unburned hydrocarbons. Due to certain regulations, the aftertreatment system 14 may be employed to reduce or substantially minimize the concentration of such byproducts prior to releasing the exhaust gas stream into the atmosphere.

One or more sensors 22 maybe included in the combustion system 20, the compressor 18, the turbine 12, various holes in a casing of the turbine system 10, borescope ports, inlets of the intake section 16, or any feasible location of the turbine system 10. In some embodiments, the sensors 22 may include any type of dynamic pressure sensors, accelerometers, strain gages, or the like. For example, the sensors 22 maybe bearing seismic sensors (e.g., accelerometers) or rotor proximity probes that are configured to listen to rotor dynamics to enable detecting tonal or discrete frequency. In some embodiments, the sensors 22 may be located over a particular blade stage in the compressor 18 and/or the turbine 12. For example, the sensors 22 may be dynamic pressure sensors that are located in a flow path, or the sensors 22 maybe accelerometers located on the casing of the compressor 18 and/or the turbine 12. In some embodiments, the sensors 22 may already be included in the assembled combustion system 20 and no other instrumentation may be added to the combustion system 20 to perform certain embodiments of the present disclosure. In some embodiments, the sensors 22 may be configured to sense pressure signals or waves in any desirable amplitude and frequency range within the compressor 18, the combustion system 20, and/or the turbine 12. Further, in some embodiments, the sensors 22 may be configured to sense thermal characteristics in or near the intake 16, the compressor 18, the combustion system 20, and/or the turbine 12.

The sensors 22 may include piezoelectric materials that generate electric signals resulting from pressure. In some embodiments, the sensors 22 may include Micro-Electrico-Mechanical Systems (MEMs) sensors, Hall effect sensors, magnetorestrictive sensors, or any other sensor designed to sense vibration, pressure, or the like. Additionally, the sensors 22 may include optical sensors that are configured to measure combustion dynamics optically. Also, the sensors 22 may include thermocouples configured to sense temperature. The sensors 22 may include communication circuitry that enables the sensors 22 to be communicatively coupled to a controller 24 and/or a computing device 25 via a wireless (e.g., Bluetooth® Low Energy, ZigBee®, WiFi®) or wired connection (e.g., Ethernet). In some embodiments, the computing device 25 may include a laptop, a smartphone, a tablet, a personal computer, a human-machine interface, or the like.

In some embodiments, the computing device 25 may be coupled to the controller 24 and/or the sensors 22, but the computing device 25 may not be configured to control the turbine system 10. That is, the computing device 25 may receive the same inputs as the controller 24 but does not provide the same outputs (e.g., control commands) to the turbine system 10. In such an embodiment, a distributed control system is enabled where the computing device 25 functions as a monitoring tool to enable providing feedback to operators, and the controller 24 controls the turbine system 10. In some embodiments, computationally expensive and demanding modeling may be delegated to the computing device 25, which may include one or more processors with enhanced performance as compared to any processor of the controller 24, as described below. It should be noted that, in some embodiments, the computing device 25 may be configured to control the turbine system 10, as well as provide feedback to operators.

In some embodiments, the sensors 22 may include a microphone or array of microphones included in the gas turbine system 10 and/or disposed external to the gas turbine system 10. For example, the microphones or array of microphones may be disposed within or near the inlet, the exhaust stack, the combustion system 20, the compressor 18, the turbine 12, or the like. In some embodiments, the microphone or array of microphones may send detected sound to the controller 24 for use in a sound level meter or series of sound level meters. In some embodiments the detected sound may be indicative of combustion dynamics.

During operation, the sensors 22 may transmit signals indicative ofpressure (e.g., static, dynamic), vibration, and/or thermal characteristics to the controller 24 and/or the computing device 25. The sensors 22 may transmit signals during any stage of operation (e.g., startup, combustion at full speed operation, shutdown) of the turbine system 10. In some embodiments, the sensors 22 may be active and transmit signals of any detected noise even when the turbine system 10 is shutdown. The controller 24 and/or the computing device 25 may receive the signals from the sensors 22 and model (e.g., mathematical, physics-based) behavior (e.g., pressure dynamics, thermal dynamics, fluid dynamics, etc.) in desired locations of the turbine system 10 based on the signals. For example, the model may simulate any dynamic pressure changes in the desired locations that is indicative of an anomaly, event, or problem. The model may utilize one or more inputs (e.g., operational parameters) derived from the sensor signals. More specifically, the model may receive inputs from the sensors 22 related to amount of fuel entering the combustion system 20, the air entering the intake 16, pressure at the intake 16, pressure at compressor discharge, temperature at compressor discharge, and/or temperature in the exhaust, among others. In addition, in some embodiments, when the modeling is performed by the computing device 25, the model may receive an input related to control parameters (e.g., outputs for fuel flow, air flow, etc.) from the controller 24 to use when modeling the behavior and generating the audio output.

It should be noted that the locations where the behavior is modeled may not include the sensors 22 due to certain constraints (e.g., physical, thermal, logistic, etc.) of those locations. Further, based on the modeled behavior, the controller 24 and/or the computing device 25 may generate audio signals suitable for outputting (e.g., via an audio output device associated with the computing device 25 and the controller 24). In addition, in some embodiments, compressor maps may be used that may include high order equation fittings. The model may use the higher order model and/or equation fitting of the compressor maps as inputs to model the anomalies, events, or problems in certain locations without sensors 22. For example, the compressor maps may be used by the model to model the pressure downstream of the compressor 18, the pressure at compressor discharge, or the like and audio signals may be generated that represent the pressure to enable detection of anomalies, events, or problems.

The controller 24 and/or the computing device 25 may each include one or more tangible, non-transitory computer-readable mediums (e.g., memories 26 and 27) storing computer instructions that, when executed by a respective processor 28 and 29 of the controller 24 and/or the computing device 25, cause the processor 28 and 29 to receive the sensor signals and/or controller outputs (e.g., control parameters being at least partially derived from the signals from the sensors 22), generate audio signals using one or more models based on the sensor signals and/or controller outputs, and output the generated audio signals via a respective audio output device 30 and 31 (e.g., speaker, bullhorn, megaphone, siren, headphone, amplifier, public address (PA) system, etc.). It should be noted that non-transitory merely indicates that the media is tangible and not a signal. Further, the controller 24 and/or the computing device 25 may include communication circuitry, such as a network interface, that is configured to receive the sensor signals and/or controller outputs and transmit the sensor signals and/or controller outputs to the processors 28 and/or 29.

The processors 28 and 29 may be any type of computer processor or microprocessor capable of executing computer-executable code. Moreover, the processors 28 and 29 may include multiple processors or microprocessors, one or more "general-purpose" processors or microprocessors, one or more special-purpose processors or microprocessors, and/or one or more application specific integrated circuits (ASICS), or some combination thereof. For example, the processors 28 and 29 may include one or more reduced instruction set (RISC) processors. In some embodiments, the processor 29 of the computing device 25 may be more powerful than the processor 28 of the controller 24 in terms of performance (e.g., processing speed).

The memories 26 and 27 may be any suitable articles of manufacture that can serve as media to store processor-executable routines, code, data, or the like. These articles of manufacture may represent computer-readable media (e.g., any suitable form of memory or storage) that may store the processor-executable code or routines used by the respective processors 28 and 29 to perform the presently disclosed techniques. For example, the memories 26 and 27 may include volatile memory (e.g., a random access memory (RAM)), nonvolatile memory (e.g., a read-only memory (ROM)), flash memory, a hard drive, or any other suitable optical, magnetic, or solid-state storage medium, or a combination thereof. The memories 26 and 27 may also be used to store any data (e.g., recordings of the generated audio output for a desired amount of time), analysis of the data, the software application, and the like.

Generally, the processors 28 and 29 may execute software applications that include a graphical user interface (GUI) that enables a user to select model outputs of the turbine system 10 for which to generate the audio output. In some embodiments, the GUI may enable the user to select model output by phenomenon, component, location in the turbine, as well as parameter to be modelled (e.g., vibration, pressure, etc.). Additional features relating to the GUI are discussed below. As may be appreciated, the operator may listen to the generated audio representing, for example, pressure or dynamics in the turbine system 10 at a location remote from the actual turbine system 10 using the controller 24 and/or the computing device 25. In some embodiments, the operator may be in relatively close proximity to the turbine system 10 while listening to the audio output via the controller 24 and/or the computing device 25.

In some embodiments, the sensors 22 may include one or more processors (e.g., controllers) capable of performing the modeling described above internally. The sensors 22 may also include one or more memories storing instructions for the modeling that are accessible and executable by the one or more sensor processors. In some embodiments, the sensors 22 (e.g., Profibus, Fieldbus, Modbus, etc.) may be communicatively coupled to each other to form a discrete loop and/or network. In this way, the sensors 22 may communicate the respective data obtained to each other to enable the modeling. In some embodiments, the controller 24 may communicate the control parameters (e.g., fuel flow, air flow, etc.) to the sensors to use in the modeling, as well. The sensors 22 may independently model the behavior of certain locations of the turbine system 10 without processing help from the computing device 25 or the controller 24. The modeled behavior may be used to generate the audio output by the sensor processors or the modeled behavior may be sent to the computing device 25 and/or the controller 24 to generate the audio output.

Based on the generated audio output that is output via the audio output devices 30 and/or 31, the operator may determine that there is an anomaly, event, or problem occurring in the gas turbine system 10. Indeed, the user may pinpoint which area of the turbine system 10 (e.g., combustion can 23, compressor 18, turbine 12, inlet, etc.) is experiencing the anomaly, event, or problem by using the disclosed techniques. For example, the operator may discern that the current noise emitted from the compressor 18 during a stage of operation sounds different (e.g., abnormal) than the noise emitted from the compressor 18 during that stage of operation when the compressor 18 is operating as expected. As such, the operator may perform a preventative action, such as shut down the turbine system 10, check the compressor 18, perform maintenance on the compressor 18, perform replacement of components in the compressor 18, schedule maintenance and/or replacement, or the like.

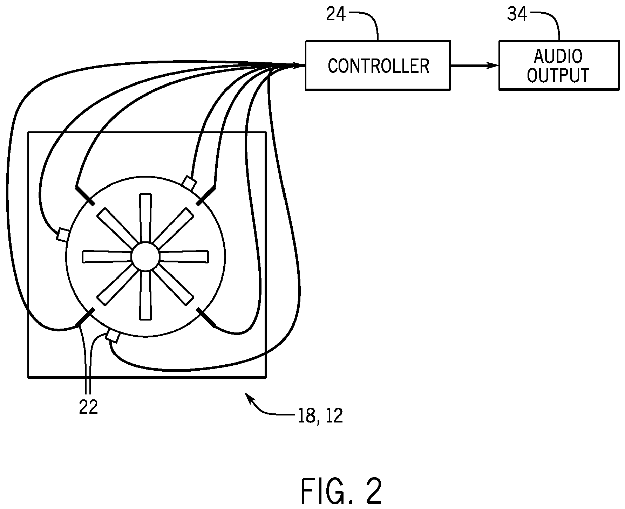

FIG. 2 is a schematic diagram of example locations of the turbine system 10 where the sensors 22 may be located, in accordance with an embodiment. The locations where the sensors 22 may be located include at least the compressor 18 (e.g., intake, stage by stage, and discharge), the turbine 12 (e.g., intake, stage by stage, and exhaust), combustion cans of the combustion system 20, the intake 16, various holes of a casing of the turbine system 10, fuel intake of the combustion system 20, a borescope port, and the like. It should be noted that there are various locations of the turbine system 10 where it is not feasible (e.g., physically, thermally, logistically, etc.) to include sensors 22 and some embodiments of the present disclosure include modeling behavior in those locations using data from the sensors 22 in other locations and/or outputs from the controller 24. Thus, it should also be noted that in some embodiments, a combination of sensors 22 (e.g., different axial or circumferential locations, monitoring different components of the turbine system 10) may be used to determine where anomalous behavior is originating. As depicted, the sensors 22 may be accelerometers, dynamic pressure sensors (e.g., probes), strain gages, thermocouples, optical probes, or the like. Further, the sensors 22 may be located circumferentially around the turbine 12 and/or the compressor 18.

Although the signals from the sensors 22 are shown as sent to the controller 24, it should be noted that the signals may also be sent to the computing device 25, which may perform similar functionality related to generating audio output using one or more models based on the signals and/or control parameters and outputting the audio as the controller 24. As depicted, in some embodiments, a respective sensor 22 may be coupled to at least each blade stage of the turbine 12 and/or the compressor 18. Thus, if there are six blade stages in the compressor 18, then six sensors 22 maybe used (e.g., one sensor 22 located proximate each blade stage). It should be noted that, in some embodiments, there may not be a one-to-one relationship between the number of sensors 22 and the number of blade stages. For example, one sensor 22 may be used to monitor all of the blade stages, a few sensors 22 may be used to monitor all of the blade stages, or more than one sensor 22 may be used to monitor a blade stage (e.g., circumferentially). Likewise, there may be numerous sensors 22 used to monitor the inlet or just a single sensor 22 may monitor the inlet.

In some embodiments, the sensors 22 may be probes that are partially inserted into the turbine 12, the compressor 18, the combustion cans of the combustion system 20, holes of a casing, borescope port, fuel intake of the combustion system 20, and/or the intake 16. The signals emitted by the sensors 22 may be sent to the controller 24 and/or the computing device 25. The controller 24 and/or the computing device 25 may include a software application that generates audio output representative of anomalies, events, or problems using one or more models based on the signals and/or controller outputs and emits the audio output 34.

It should be noted that the software application may be downloadable from an application distribution platform installed on the controller 24 and/or the computing device 25. The application distribution platform may be proprietary and private. Thus, in some embodiments, downloading of the software application that enables listening to the audio representative of the modeled pressure or vibration of the turbine system 10 during operation or while the turbine system 10 is shutdown may be restricted to authorized users. In this way, the application distribution platform may perform authentication of the controller 24 and/or the computing device 25 that requests to download the software application. The application distribution platform may be connected to a cloud-based computing system that maintains the software application, as well as other software applications and data. Also, the software application may be connected to the cloud-based computing system and may send data and receive data from the cloud-based computing system.

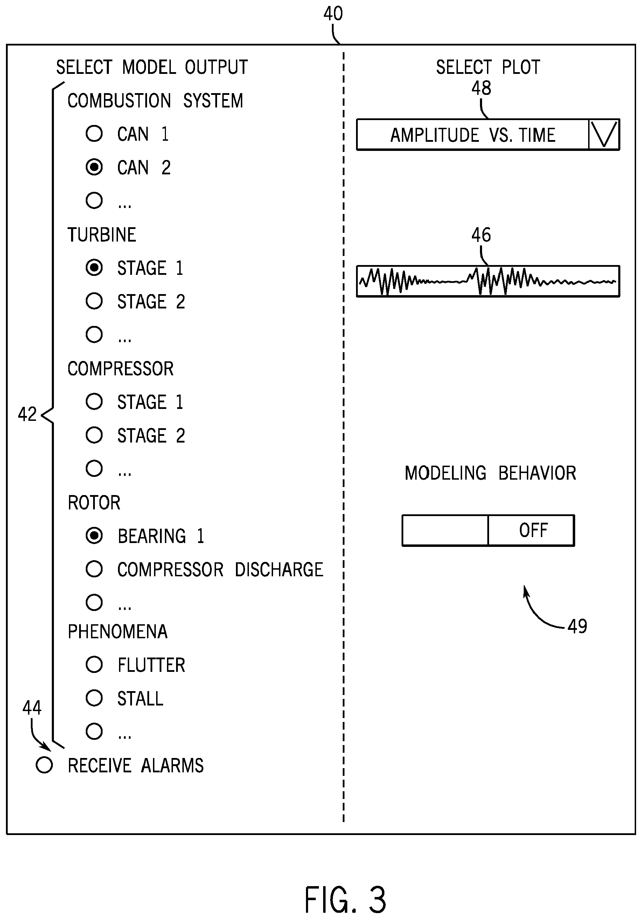

FIG. 3 is a screenshot of a graphical user interface (GUI) 40 that displays a list 42 of model outputs available for which to generate audio output and receives a user selection of the model output, in accordance with an embodiment. Although the model outputs are for locations and phenomena (e.g., flutter, stall, compressor surge, etc.) in the turbine system 10 in the depicted list 42, it should be noted that the list 42 may include other model output selections, such as by component, parameter (e.g., vibration, pressure, etc.), and the like. In some embodiments, the list 42 may include options for "high-impact items", "high-risk items", and/or "sort by event". Sort by event may refer to fuel transfers, loading, peak, or the like. Additionally, the GUI 40 displays an input selector 44 related to whether the user desires to receive control alarms related to the turbine system 10. As depicted, the list 42 includes radio button selectors for "CAN 1," "CAN 2," ... of the combustion system 20, "STAGE 1," "STAGE 2," ... of the turbine 12, "STAGE 1," "STAGE 2," ... of the compressor 18, "BEARING 1," and "COMPRESSOR DISCHARGE," ... of the rotor, and "FLUTTER," and "STALL," ... of phenomena. Thus, as may be appreciated, any number of locations and/or phenomena may be selectable through the GUI 40. For example, as depicted, "CAN 2," "STAGE 1," and "Bearing 1" are selected. Although just one radio button is displayed for a particular blade stage of the turbine 12 and the compressor 18, it should be noted that additional radio buttons may be displayed as selectable to the user. It should be noted that a "select all" radio button selector may be included for each component of the turbine system 10. For example, a "select all" radio button selector may be included under each heading for the combustion system 20, the turbine 12, the compressor 18, the rotor, phenomena, and so forth. When the user selects the model output locations and/or phenomena from the list 42, the processor 28 and/or 29 may use one or more inputs from the available sensors (e.g., compressor discharge pressure, compressor discharge temperature, etc.) and/or controller outputs (e.g., fuel flow, air flow, etc.) to model behavior in the selected locations and/or phenomena and generate audio output representing the modeled behavior.

In addition, the GUI 40 may display the list 42 as including model output selected to be listened to. It should be appreciated that there is a distinction between the model output selected to be generated and the model output selected to be listened to. For example, in some embodiments, the user may select to generate numerous model outputs at once and listen to them one at a time. Additionally or alternatively, in some embodiments, it may be desirable to listen to more than one generated output at a time.

Further, although radio button selectors are used in the list 42, it should be noted that any selection input element may be used such as a dropdown list, a checkbox, an input textbox, or the like. Additionally, in some embodiments, voice commands may be used to select the model outputs to listen to from the list 42. Thus, the controller 24 and/or the computing device 25 may include a microphone that is configured to receive sounds and the processor 28 and 29 maybe configured to process the sounds in order to select the desired model outputs to use when generating audio output using the one or more models.

The user may use an input peripheral such as a mouse to move an arrow or hand selection icon around the GUI 40. When the user depresses and releases a button on the mouse and the selection icon is above a radio button selector, the radio button selector may toggle to a selected state if in a deselected state or may toggle to a deselected state if already in a selected state. Additionally, the input peripheral may include a touchscreen. When the user touches a portion of the touchscreen where a radio button selector is located, the radio button selector may toggle to a selected state if in a deselected state or may toggle to a deselected state if already in a selected state.

In some embodiments, the model output locations in the combustion system 20, the turbine 12, the compressor 18, and/or the rotor may be represented graphically, similar to FIG. 2, on the GUI 40. In this way, instead of, or in addition, to selecting the model output locations from the list 42, the user may select a graphical representation of the model output location on a visualization of the turbine system 10 to use to generate audio using the one or more models. Additionally, the user may select the model output location from the list 42 and the graphical representation of the combustion system 20, the turbine 12, the compressor 18, and/or the rotor may be highlighted in the turbine system 10 displayed on the GUI 40 depending on the selection. Further, the locations of sensors 22 that are used in the modeling at the selected location may be highlighted to provide an indication of which senor signals were used as input to the model.

When the user selects a particular model output location, the GUI 40 may display a visualization 46 of a sound wave representative of the generated audio emitted. Thus, the user may be able to visualize the sound wave on the GUI 40 via the visualization 46 that is being displayed by a display of the controller 24 and/or the computing device 25. In some embodiments, a respective visualization 46 may include a respective sound wave for the respective locations that are selected. Additionally or alternatively, one or more visualizations 46 may include numerous sound waves to be overlaid. That is, one visualization 46 may include depictions of multiple sound waves to enable the user to compare the sound waves relative to one another more clearly. It should be noted that the information displayed on the visualization 46 may be performed independently of the audio output 34. For example, the audio output 34 may emit noises representing modeled pressure downstream of the compressor 18, while the visualization 46 displays sound waves overlaid for the modeled pressure downstream of the compressor 18 and combustion.

Although the embodiment of the visualization 46 depicted is a time domain output (amplitude versus time), it should be appreciated that the visualization 46 may be a spectral output (frequency versus amplitude). A spectral output may enable a user to identify the frequency associated with any abnormality detected and may guide an action to be taken. Further, in some embodiments, the GUI 40 may provide an option to select/deselect the plots to be displayed. For example, a graphical selector element, such as dropdown list 48, may be used to enable the user to select whether to display the time domain outputs, spectral outputs, or both.

Further, the software application associated with the GUI 40 may output a live feed of the generated audio associated with the selected model output location to the respective audio output device 30 and/or 31 of the controller 24 and/or the computing device 25. Thus, in some embodiments the user may listen to the generated audio associated with the selected model output location and/or view the sound wave associated with the audio of the selected model output location. Using both the audio output 34 and the visual representation 46 in conjunction may enable the user to double check a determination of whether a modeled behavior indicates an anomaly, event, or problem is present. For example, the sound wave visualization 46 may be used to confirm that a loud or unexpected noise was modeled based on data from the associated sensors 22 and/or the controller outputs during operation of the turbine system 10 and the noise was not due to some event near the operator using the computing device 25. That is, the generated audio output 34 and the sound wave visualization 46 may be used as a check on each other.

In some embodiments, the GUI 40 may also include a modeling behavior input selector 49, which enables the operator to turn on or off modeling behavior in desired locations of the turbine system 10. As depicted, the modeling behavior input selector 49 may include a sliding bar input selector. However, it should be understood that any suitable input selector may be used such as radio buttons or the like.

Using the list 42 on the GUI 40, the user may select the model output(s) for which to generate audio using one or more models based on signals from associated sensors and/or controller outputs. For example, the user may select just one model output location, one model output phenomena, may select just a particular component (e.g., one or more stages of the compressor 18, the turbine 12, etc.), or may select all of the model output locations at once. In this way, the user may detect whether an anomaly, event, or problem is present in the turbine system 10 in general or on an individual component basis by listening to generated audio output 34 representing the modeled behavior (e.g., pressure, vibration, thermal) within or near (e.g., downstream, upstream) specific components during operation. As previously noted, the sensors 22 may emit signals during full-speed operation of the turbine system 10, any other stage of operation, or even when the turbine system 10 is shutdown. The generated audio output 34 may be provided in real-time or near real-time as operation (e.g., combustion) is occurring due to the simulated real-time feedback provided by the one or more models. Also, the generated audio output 34 may be provided via the controller 24 and/or the computing device 25, which may be physically located away from the actual turbine system 10 (e.g., in a control room or in a separate building).

Further, using the input selector 44 for control alarms, the GUI 40 may provide an input selection to the operator to select whether to receive control alarms. Receiving information (e.g., type of alarm, status, parameters, timestamp) related to control alarms may be used in conjunction with the generated audio output 34 during operation of the turbine system 10 to perform diagnostics. For example, certain control alarms may relate to vibration above a threshold, oil pressure below a threshold, oil pressure above a threshold, bearing temperature above a threshold, cooling water failure, power failure, or the like. The user may view the control alarm that is currently activated and listen to the audio output 34 generated using one or more models based on inputs from one or more of the sensors 22 and/or the controller 24 to determine that the irregular audio output 34 is caused by the event indicated by the control alarm. Likewise, when the user hears irregular, generated audio output 34 during operation and the control alarms are not triggered or activated, then the user may determine that the control alarms should be recalibrated or checked to make sure they are operating properly, the sensors 22 should be recalibrated or checked, the one or more models should be adjusted or checked, or the like.

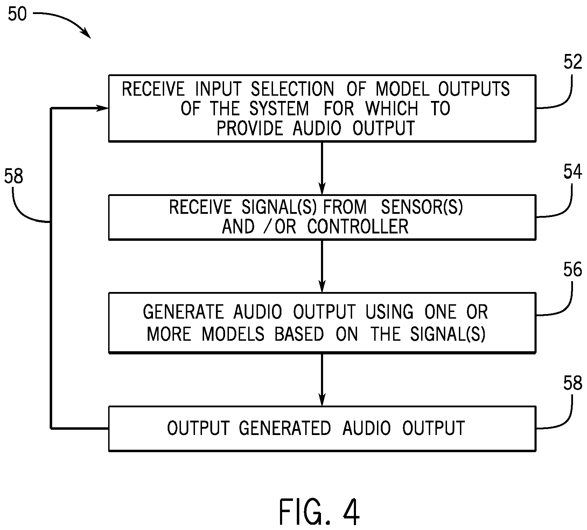

FIG. 4 is a flow chart illustrating an embodiment of a method 50 for modeling to detect anomalies, events, or problems via generated audio output, in accordance with an embodiment. Although the following description of the method 50 is described with reference to the processor 29 of the computing device 25, it should be noted that the method 50 may be performed by other processors disposed on other devices that may be capable of communicating with the sensors 22, such as the processor 28 of the controller 24, processors of the sensors 22, or other components associated with the turbine system 10. Additionally, although the following method 50 describes a number of operations that may be performed, it should be noted that the method 50 may be performed in a variety of suitable orders and all of the operations may not be performed. It should be appreciated that the method 50 may be wholly executed by the computing device 25 or the execution may be distributed between the computing device 25 and the controller 24. Further, the method 50 may be implemented as computer instructions included in a software application stored on the memory 26 or 27. As previously discussed, the software application may be obtainable from a software distribution platform.

Referring now to the method 50, the processor 29 may receive (block 52) an input selection of the model output location(s) for which to generate audio output 34. It should be understood that in some embodiments, instead of location, the input selection may be of model output phenomenon, component of the turbine system 10, parameter (e.g., vibration, pressure, etc.), or the like. The input selection may be entered by a user using the GUI 40 described above. For example, the user may select the model output location from the list 42. The user may select a subset of the model output locations (one or more but not all), or all of the model output locations. Based on the input selection, the processor 29 may cause a network interface to tune-in to the sensors 22 associated with the selected model output location (e.g., compressor 18, intake 16, turbine 12, combustion can 23, holes 34, fuel intake, borescope port 36, etc.).

Additionally or alternatively, the network interface may already be communicatively coupled to the sensors 22 associated with the selected model output location.

The processor 29 may receive (block 54) signals (e.g., inputs) from the sensors 22 associated with the selected model output location(s) and/or controller outputs (e.g., fuel flow, air flow, etc.). As previously described, each sensor 22 may include a dynamic pressure sensor, probe, gage, accelerometer, thermocouple, or the like that senses pressure waves, vibration waves, or thermal characteristics in the particular location and emits the appropriate signals.

Once the signals (e.g., inputs) are received, the processor 29 may generate (block 56) audio output 34 using one or more models based on the sensor signals and/or the controller outputs. As previously discussed, a first model may use physics-based equations that model behavior (e.g., pressure dynamics, fluid dynamics, thermal dynamics, etc.) in the turbine system 10 based on the sensor signals and/or the controller outputs. For example, various operational parameters (e.g., derived from sensor signals) may be used as inputs to the first model may include amount of fuel intake, amount of air entering the intake 16, pressure at the intake 16, pressure at compressor discharge, temperature at compressor discharge, and/or temperature in the exhaust from the turbine 12. In some embodiments, a second model (e.g., compressor map) may be used that includes higher order equation fitting that provides input related to compressor discharge pressure to the first model. In some embodiments, the first and second models may be combined into one model. The processor 29 may generate the audio output 34 representing the modeled behavior. In some embodiments, the processor 29 may perform additional processing or calculations on the audio output 34. For example, the processor 29 may perform A-weighting, B-weighting, C-weighting, D-weighting, reverse A-weighting, reverse B-weighting, reverse C-weighting, reverse D-weighting, or the like. It should be appreciated that any type of suitable frequency-dependent amplification or filtering may be performed by the processor 29.

The processor 29 may output (block 58) the generated audio output 34 via the audio output device 30 or 31. The user may listen to the audio output 34 (based on the modeled behavior) to detect whether there is an anomaly, event, or problem present in or near the selected model output location(s) or the turbine system 10 in general. That is, an irregular noise generated and emitted during operation may be indicative of an issue with or near the selected model output location or with the turbine system 10 as a whole. Anomalies that may be detected may include flutter, rotating stall, whistling caused by resonance of the compressor bleed cavities and/or various cavities or wheel spaces in the turbine 12, compressor surge, and/or loose items (e.g., bolts, debris) inside of components of the turbine system 10.

If the user selected to listen to the audio generated for a single model output location and determines that the generated audio output 34 is satisfactory (e.g., regular noise during operation), then the method 50 maybe repeated, as shown by arrow 58, and the user may select the next model output location for which to generate audio output. The method 50 maybe repeated until the user listens to generated audio for all of the model output locations in the turbine system 10 or until the operator identifies a modeled behavior that represents an anomaly, event, or problem in the turbine system 10 and performs a preventative action, as described above. In some embodiments, the user may select a combination of the model output locations for which to generate audio output.

Technical effects of the subject matter include modeling to detect an anomaly, event, or problem in a turbine system 10 using generated audio output. The generated audio output 34 may be generated using one or more models based on data obtained via one or more sensors 22 in any feasible location of the turbine system 10 and/or controller output. In some embodiments, the sensors 22 may already be installed in the turbine system 10, and thus, no additional instrumentation is installed to perform the disclosed techniques. The sensors 22 may sense pressure (static or dynamic) or vibration waves and/or temperature. Further, the sensors 22 may emit the signals to the controller 24 and/or the computing device 25, which may execute a software application to generate audio output 34 using the one or more models based on the sensor signals and/or controller outputs and to emit via the audio output devices 30 and 31. In addition, some embodiments enable the user to select the model output by phenomenon, component, location in the turbine system 10, and/or parameter (e.g., vibration, pressure, etc.) for which to generate audio output.

This written description uses examples to disclose the subject matter, and also to enable any person skilled in the art to practice the subject matter, including making and using any devices or systems and performing any incorporated methods. The patentable scope of the subject matter is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal language of the claims.

Various aspects and embodiments of the present invention are defined by the following numbered clauses:
1. A turbine system comprising:
   a plurality of sensors, each sensor of the plurality of sensors disposed in a respective location of the turbine system and generating a respective signal;
   a controller capable of generating a controller output, the controller output being at least partially derived from the respective signal from one or more of the plurality of sensors; and
   an electronic device comprising:
      one or more memories storing one or more processor-executable routines; and
      one or more processors configured to access and execute the one or more routines encoded by the one or more memories wherein the one or more routines, when executed, cause the one or more processors to:
         receive one or more inputs, the inputs being at least one of the respective signals from one of the plurality of sensors, the controller output, or some combination thereof; and
         generate an audio output using one or more models that incorporate the one or more inputs.
2. The turbine system of clause 1, wherein the one or more routines, when executed, cause the one or more processors to output the generated audio output via one or more audio output devices.
3. The turbine system of clause 1 or 2, wherein the plurality of sensors comprise one or more dynamic pressure sensors, static pressure sensors, thermocouples, microphones, clearance probes, optical probes, accelerometers, strain gages, or some combination thereof.
4. The turbine system of any preceding clause, wherein the one or more models comprise a first model that utilizes the one or more inputs related to fuel intake, air flow, pressure at an intake, pressure at discharge of a compressor, temperature at discharge of the compressor, temperature in exhaust of a turbine, or some combination thereof in generating the audio output.
5. The turbine system of any preceding clause, wherein the one or more models is derived from a compressor map.
6. The turbine system of any preceding clause, wherein the generated audio output is indicative of an anomaly, event, or problem in at least one area of the turbine system.
7. The turbine system of any preceding clause, wherein the anomaly, event, or problem comprises flutter, rotating stall, whistling caused by resonance of a compressor bleed cavity in the turbine system, compressor surge, or some combination thereof.
8. The turbine system of any preceding clause, wherein the electronic device comprises a computing device that does not control operation of the turbine system.
9. The turbine system of any preceding clause, wherein the plurality of sensors are configured to sense pressure waves, vibration waves, temperature, static pressure, or some combination thereof.
10. The turbine system of any preceding clause, wherein the one or more routines are included in a software application downloaded via a software distribution platform encoded by the one or more memories.
11. A device, comprising:
   one or more memories storing one or more processor-executable routines; and
   one or more processors configured to access and execute the one or more routines encoded by the one or more memories wherein the one or more routines, when executed, cause the one or more processors to:
      receive one or more inputs, the inputs being at least one of a respective signal from a plurality of sensors of a turbine system, an output of a controller of the turbine system, or some combination thereof; and
      generate an audio output using one or more models that incorporate the one or more inputs.
12. The device of any preceding clause, wherein the one or more routines, when executed, cause the one or more processors to output the generated audio output via one or more audio output devices.
13. The device of any preceding clause, wherein the one or more models model behavior of a component of a compressor, a component of a combustion system, a component of a turbine, or some combination thereof of the turbine system using one or more physics-based equations, one or more compressor maps, or both.
14. The device of any preceding clause, wherein the device comprises a computing device separate from a controller of the turbine system, and the one or more processors of the device comprises more processing power than a second processor of the controller.
15. The device of any preceding clause, wherein the one or more routines, when executed, cause the one or more processors to receive a model output selection from a list on a graphical user interface used to select select one or more locations or components of the turbine system for which the audio output is to be generated using the one or more models.
16. The device of any preceding clause, wherein the device comprises a sensor of the plurality of sensors.
17. One or more tangible, non-transitory computer-readable mediums comprising instructions that, when executed by one or more processors, cause the one or more processors to:
   receive one or more inputs, the inputs beings at least one of a respective signal from a plurality of sensors, a controller output, or some combination thereof, wherein each sensor of the plurality of sensors is disposed at a respective location of a turbine system; and
   generate an audio output using one or more models that incorporate the one or more inputs.
18. The one or more computer-readable mediums of any preceding clause, wherein the instructions, when executed by the processor, cause the processor to output the generated audio output via one or more audio output devices.
19. The one or more computer-readable mediums of any preceding clause, wherein the one or more models utilize the one or more inputs related to fuel intake, air flow, pressure at an intake, pressure at compressor discharge, temperature at compressor discharge, exhaust temperature of a turbine, or some combination thereof, and outputs behavior at an area of the turbine system, wherein the behavior is used by the one or more processors to generate the audio output that indicates one or more anomalies, events, or problems are present in the location for which audio output was generated by the one or more models.
20. The one or more computer-readable mediums of any preceding clause, wherein the one or more computer-readable mediums and the one or more processors are included in a computing device separate from a controller of the turbine system, wherein the one or more processors have more computing power than any processor included in the controller.

## Claims

1. A turbine system comprising:
a plurality of sensors, each sensor of the plurality of sensors disposed in a respective location of the turbine system and generating a respective signal;
a controller capable of generating a controller output, the controller output being at least partially derived from the respective signal from one or more of the plurality of sensors; and
an electronic device comprising:
one or more memories storing one or more processor-executable routines; and
one or more processors configured to access and execute the one or more routines encoded by the one or more memories wherein the one or more routines, when executed, cause the one or more processors to:
receive one or more inputs, the inputs being at least one of the respective signals from one of the plurality of sensors, the controller output, or some combination thereof; and
generate an audio output using one or more models that incorporate the one or more inputs.

2. The turbine system of claim 1, wherein the one or more routines, when executed, cause the one or more processors to output the generated audio output via one or more audio output devices.

3. The turbine system of claim 1 or 2, wherein the plurality of sensors comprise one or more dynamic pressure sensors, static pressure sensors, thermocouples, microphones, clearance probes, optical probes, accelerometers, strain gages, or some combination thereof.

4. The turbine system of claim 1, 2 or 3, wherein the one or more models comprise a first model that utilizes the one or more inputs related to fuel intake, air flow, pressure at an intake, pressure at discharge of a compressor, temperature at discharge of the compressor, temperature in exhaust of a turbine, or some combination thereof in generating the audio output.

5. The turbine system of any preceding claim, wherein the one or more models is derived from a compressor map.

6. The turbine system of any preceding claim, wherein the generated audio output is indicative of an anomaly, event, or problem in at least one area of the turbine system.

7. The turbine system of any preceding claim, wherein the anomaly, event, or problem comprises flutter, rotating stall, whistling caused by resonance of a compressor bleed cavity in the turbine system, compressor surge, or some combination thereof.

8. The turbine system of any preceding claim, wherein the electronic device comprises a computing device that does not control operation of the turbine system.

9. The turbine system of any preceding claim, wherein the plurality of sensors are configured to sense pressure waves, vibration waves, temperature, static pressure, or some combination thereof.

10. The turbine system of any preceding claim, wherein the one or more routines are included in a software application downloaded via a software distribution platform encoded by the one or more memories.

11. A device, comprising:
one or more memories storing one or more processor-executable routines; and
one or more processors configured to access and execute the one or more routines encoded by the one or more memories wherein the one or more routines, when executed, cause the one or more processors to:
receive one or more inputs, the inputs being at least one of a respective signal from a plurality of sensors of a turbine system, an output of a controller of the turbine system, or some combination thereof; and
generate an audio output using one or more models that incorporate the one or more inputs.

12. The device of claim 11, wherein the one or more routines, when executed, cause the one or more processors to output the generated audio output via one or more audio output devices.

13. The device of claim 11 or 12, wherein the one or more models model behavior of a component of a compressor, a component of a combustion system, a component of a turbine, or some combination thereof of the turbine system using one or more physics-based equations, one or more compressor maps, or both.

14. The device of claim 11, 12 or 13, wherein the device comprises a computing device separate from a controller of the turbine system, and the one or more processors of the device comprises more processing power than a second processor of the controller.

15. One or more tangible, non-transitory computer-readable mediums comprising instructions that, when executed by one or more processors, cause the one or more processors to:
receive one or more inputs, the inputs beings at least one of a respective signal from a plurality of sensors, a controller output, or some combination thereof, wherein each sensor of the plurality of sensors is disposed at a respective location of a turbine system; and
generate an audio output using one or more models that incorporate the one or more inputs.
